(19) Europäisches Patentamt
European Patent Office
Office européen des brevets

(11) **EP 0 859 458 B1**

(12) **FASCICULE DE BREVET EUROPEEN**

(45) Date de publication et mention
de la délivrance du brevet:
**09.04.2003 Bulletin 2003/15**

(51) Int Cl.⁷: **H03B 5/36**

(21) Numéro de dépôt: **98410003.2**

(22) Date de dépôt: **22.01.1998**

(54) **Circuit de modulation de fréquence d'un oscillateur à quartz**

Schaltung zur Frequenzmodulation eines Quarzoszillators

Circuit for frequency modulation of a quartz oscillator

(84) Etats contractants désignés:
**DE FR GB IT**

(30) Priorité: **24.01.1997 FR 9700969**

(43) Date de publication de la demande:
**19.08.1998 Bulletin 1998/34**

(73) Titulaire: **STMicroelectronics S.A.**
**92120 Montrouge (FR)**

(72) Inventeur: **Sirito-Olivier, Philippe**
**38120 Saint Egreve (FR)**

(74) Mandataire: **de Beaumont, Michel et al**
**1, rue Champollion**
**38000 Grenoble (FR)**

(56) Documents cités:
**GB-A- 2 039 438          US-A- 3 728 645**
**US-A- 4 095 255          US-A- 5 559 479**

**Description**

La présente invention concerne les oscillateurs à quartz commandés en tension (VCXO) et, plus particulièrement, un circuit intégré propre à moduler, par une boucle de modulation de phase commandée en tension, la fréquence d'un oscillateur à quartz.

Plusieurs solutions existent pour moduler la fréquence d'un oscillateur à quartz commandé en tension.

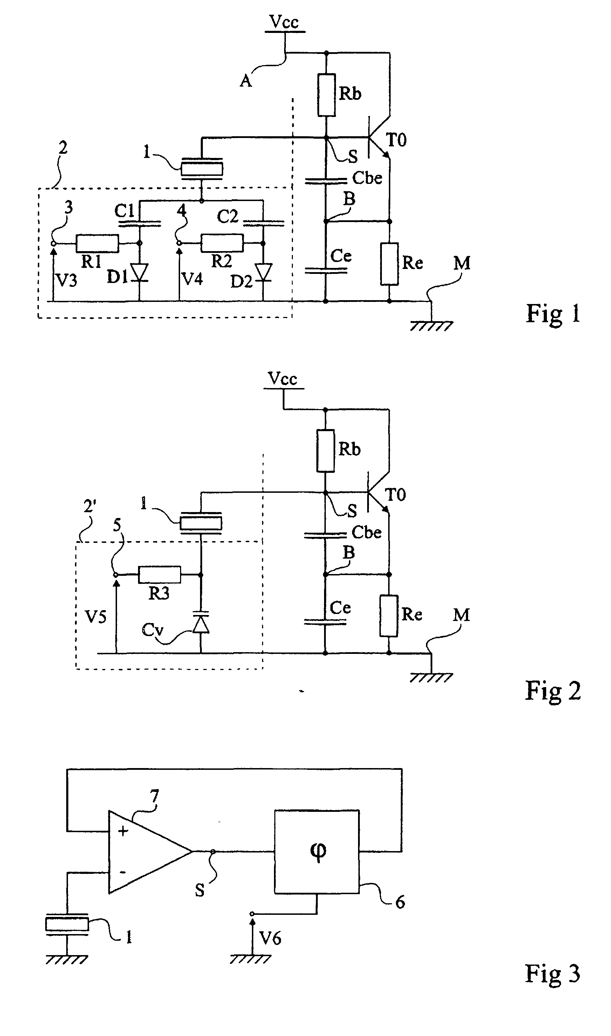

Les figures 1 et 2 représentent deux exemples classiques d'oscillateurs à quartz commandés en tension, basés sur des structures de type Colpitts. La figure 1 représente un oscillateur de type Colpitts dans lequel la fréquence est modulée, de façon discrète, par une commutation de condensateurs en série avec le quartz. La figure 2 représente un exemple d'oscillateur de type Colpitts dans lequel la fréquence est modulée, de façon linéaire, au moyen d'une diode à capacité variable (varicap).

Un oscillateur de type Colpitts est, par exemple, constitué d'un transistor d'oscillation To de type NPN, dont le collecteur est connecté à une première borne A d'alimentation positive Vcc et dont l'émetteur est relié au point milieu B d'une association en série de deux condensateurs Cbe et Ce entre la base du transistor To et une deuxième borne M d'alimentation, généralement reliée à la masse. Une première borne d'un quartz 1 est reliée à la base du transistor To qui constitue une borne S de sortie du signal oscillant. Une deuxième borne du quartz est, quand on souhaite moduler la fréquence d'oscillation, reliée à la borne M par l'intermédiaire d'un circuit capacitif de modulation, respectivement, 2 (figure 1) ou 2' (figure 2). Des résistances de polarisation Rb, Re sont généralement prévues entre la borne S et la borne A et entre l'émetteur du transistor To et la borne M. Un oscillateur de type Colpitts peut également être réalisé avec d'autres types de transistors (PNP, JFET, ...).

Le fonctionnement d'un oscillateur de type Colpitts est parfaitement connu. Pour que le montage oscille, deux conditions doivent être respectées. Une première condition est que la résistance vue par le quartz 1 doit être, en valeur absolue, supérieure à sa propre résistance série. Une deuxième condition est que la résistance vue par le quartz doit être négative. Le rôle du transistor To et des condensateurs Cbe et Ce est précisément de créer une résistance négative entre les bornes B et M. La fréquence d'oscillation est fixée par la capacité équivalente du montage en parallèle sur le quartz 1.

Le montage représenté à la figure 1 est plus particulièrement destiné à une modulation par saut de fréquence (FSK).

Le circuit 2 de modulation de fréquence est constitué, par exemple, de deux condensateurs C1, C2 intercalés, en parallèle, entre le quartz 1 et la borne M. Chaque condensateur C1, C2 est associé, en série, avec une diode D1, D2 dont la cathode est connectée à la borne M. L'anode de chaque diode D1, D2 est reliée au condensateur correspondant C1, C2 et, par l'intermédiaire d'une résistance R1, R2, à une borne 3, 4 d'application d'une tension V3, V4 de commande. Les diodes D1 et D2 sont des diodes présentant une impédance série très élevée dans leur état bloqué et très faible dans leur état passant. Quand une des tensions V3, V4 est suffisamment positive, le condensateur correspondant C1, C2 participe, par le rebouclage à la masse, à la capacité présente en parallèle sur le quartz 1. Ainsi, la modulation de fréquence s'effectue par l'application d'une tension sur une des bornes 3 ou 4 ou sur ces deux bornes.

Le montage de la figure 2 est plus particulièrement destiné à une modulation linéaire (FM).

Le circuit 2' de modulation est constitué d'une diode varicap Cv intercalée entre le quartz 1 et la borne M. L'anode de la diode varicap Cv est connectée à la borne M et sa cathode est reliée à une borne du quartz 1 et, par l'intermédiaire d'une résistance R3, à une borne 5 d'application d'une tension V5 de commande de l'oscillateur. La modulation de fréquence s'effectue en faisant varier la tension V5 qui modifie la capacité équivalente de la diode varicap Cv.

Un inconvénient des montages de type Colpitts classiques est qu'ils nuisent à la capacité d'intégration du montage oscillateur. En effet, les circuits de modulation 2 (figure 1) ou 2' (figure 2) doivent, en pratique, être réalisés sous la forme de circuits externes à un circuit intégré comprenant le montage de type Colpitts proprement dit. En particulier, la réalisation d'une diode varicap sous forme intégrée est très encombrante.

Pour réaliser un oscillateur à quartz commandé en tension sous forme de circuit où tous les composants (à l'exception du quartz) sont intégrés, on a généralement recours à un autre type de montage dont un exemple est illustré par la figure 3. Le principe d'un tel montage est d'utiliser un déphaseur variable 6 sur une boucle de réaction reliant une sortie S d'un amplificateur différentiel 7 à la borne d'entrée positive de cet amplificateur 7. Le quartz 1 est connecté entre la borne d'entrée négative de l'amplificateur 7 et la masse. Le déphaseur variable 6 apporte un retard dans la boucle de réaction. L'importance de ce retard est commandée par une tension V6 appliquée sur une borne de commande du déphaseur 6. Le signal modulé est prélevé en sortie S de l'amplificateur 7.

Dans un tel montage, l'amplificateur 7 et le déphaseur 6 peuvent être réalisés sous forme de circuit intégré. Toutefois, la plage de modulation est beaucoup plus limitée que dans un oscillateur de type Colpitts.

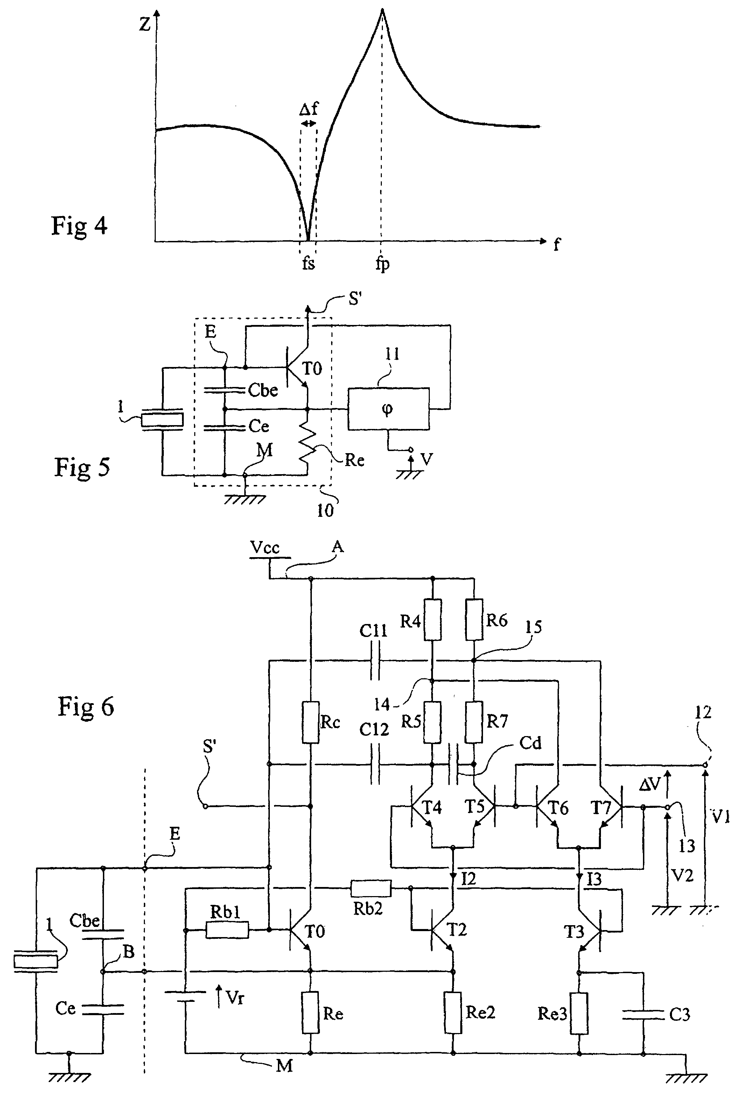

La figure 4 illustre la caractéristique impédance-fréquence d'un quartz. Un quartz possède deux fréquences d'oscillation. Une première fréquence fs, fixe, correspond à la résonance série du quartz et est fonction des caractéristiques intrinsèques au quartz, à savoir son inductance série et sa capacité série. A la fréquence fs, l'impédance Z du quartz correspond à sa résistance série. Une deuxième fréquence d'oscillation fp du quartz correspond à la résonance parallèle du quartz et est variable. La fréquence fp est fonction de l'inductance série intrinsèque au quartz et de la capacité en parallèle sur cette inductance série. La fréquence fp est donc variable en fonction des capacités ramenées en parallèle aux bornes du quartz. A la fréquence fp, l'impédance du quartz est maximale.

Un montage tel que représenté à la figure 3 utilise la résonance série du quartz car l'impédance du quartz doit être minimale pour que l'entrée négative de l'amplificateur 7 soit sensiblement à la masse, faute de quoi l'oscillation se trouve amortie. Or, quand on fait varier la fréquence autour de la fréquence fs au moyen du déphaseur 6, l'impédance du quartz augmente. On doit donc veiller à ce que la plage Δf de modulation de la fréquence soit suffisamment faible pour que l'impédance du quartz reste suffisamment basse, afin que le montage oscille sans amortissement.

Un autre inconvénient d'un montage tel que représenté à la figure 3 est que l'amplitude du signal modulé n'est pas stable en raison de la variation d'impédance du quartz. En outre, la fréquence centrale (fs) de l'oscillateur n'est pas réglable.

Le document US-A-3 728 645 décrit un oscillateur à quartz dans lequel un circuit actif fait varier la fréquence d'oscillation. Le circuit actif introduit une capacité variable entre la base du transistor d'oscillation et la masse. Un inconvénient d'un tel circuit est que sa commande nécessite une modulation dynamique et ne permet pas de fixer la fréquence d'oscillation à partir d'un signal continu.

On connaît également des oscillateurs qui utilisent un nombre impair d'inverseurs en série, raccordés en parallèle sur un quartz dont les deux bornes sont connectées à la masse par l'intermédiaire de condensateurs. Un commutateur court-circuite un nombre pair d'inverseurs pour modifier le temps de propagation. De tels oscillateurs sont exclusivement destinés à une modulation FSK.

La présente invention vise à proposer un nouvel oscillateur à quartz commandé en tension qui pallie aux inconvénients des montages classiques.

En particulier, la présente invention vise à proposer un oscillateur qui puisse être intégré avec un encombrement réduit.

L'invention vise également à proposer un oscillateur dont la modulation en fréquence puisse s'effectuer sur une large plage de fréquences.

L'invention vise également à proposer un oscillateur dans lequel l'amplitude du signal de sortie reste sensiblement constante quelle que soit la fréquence.

L'invention vise également à ce que la fréquence d'oscillation puisse être fixée par un niveau de tension continu.

L'invention vise en outre à proposer un montage oscillateur dont la structure est adaptée à une modulation FM et à une modulation FSK.

Pour atteindre ces objets, la présente invention prévoit un oscillateur à quartz commandé en tension, comportant un transistor d'oscillation dont la base est reliée à une première borne d'un quartz et dont l'émetteur est connecté, par l'intermédiaire d'un premier condensateur, à une deuxième borne du quartz reliée à une première borne d'alimentation, et un circuit actif, commandé en tension et distinct du transistor d'oscillation, introduisant une capacité variable entre la base et l'émetteur du transistor d'oscillation.

Selon un mode de réalisation de la présente invention, l'oscillateur comporte un deuxième condensateur connecté entre la base et l'émetteur du transistor d'oscillation.

Selon un mode de réalisation de la présente invention, le circuit actif est constitué d'une structure à commande différentielle recevant un signal modulant.

Selon un mode de réalisation de la présente invention, le circuit actif comporte :

une première partie modulante constituée d'un premier et d'un deuxième transistors à émetteurs communs, dont les bases sont respectivement reliées à une première et à une deuxième bornes d'application du signal modulant, et dont les collecteurs sont reliés par un condensateur de modulation, le collecteur du premier transistor étant connecté, par l'intermédiaire d'une première association en série de deux résistances, à une deuxième borne d'alimentation, et le collecteur du deuxième transistor étant relié, par l'intermédiaire d'une deuxième association en série de deux résistances, à la deuxième borne d'alimentation ;

une deuxième partie modulante constituée d'un troisième et d'un quatrième transistors à émetteurs communs, dont les bases sont respectivement reliées à la deuxième borne et à la première borne d'application du signal modulant, le collecteur du troisième transistor étant relié au point milieu de ladite première association en série et le collecteur du quatrième transistor étant relié au point milieu de ladite deuxième association en série ;

un montage de gain à transistors, intercalé entre les émetteurs des quatre premiers transistors et la première borne d'alimentation ; et

au moins un premier condensateur de boucle, connecté entre le collecteur du premier transistor et la base du transistor d'oscillation.

Selon un mode de réalisation de la présente invention, ledit deuxième point milieu est relié, par l'intermédiaire d'un deuxième condensateur de boucle, à la base du transistor d'oscillation.

Selon un mode de réalisation de la présente invention, les résistances desdites associations en série sont dimensionnées en fonction de la plage de modulation souhaitée autour d'une fréquence centrale d'oscillation.

Selon un mode de réalisation de la présente invention, le montage de gain est constitué d'un cinquième transistor et d'un sixième transistor montés en bases communes, le collecteur du cinquième transistor étant relié aux émetteurs des premier et deuxième transistors, le collecteur du sixième transistor étant relié aux émetteurs des troisième et quatrième transistors, l'émetteur du cinquième transistor étant relié à l'émetteur du transistor d'oscillation et l'émetteur du sixième transistor étant relié, par l'intermédiaire d'un troisième condensateur, à la première borne d'alimentation.

Selon un mode de réalisation de la présente invention, les bases des cinquième et sixième transistors sont reliées, par l'intermédiaire d'une première résistance de base, à une borne d'une source de tension constante, la base du transistor d'oscillation étant également reliée à ladite borne de la source de tension par l'intermédiaire d'une deuxième résistance de base.

Selon un mode de réalisation de la présente invention, les émetteurs respectifs du transistor d'oscillation et des cinquième et sixième transistors sont reliés, par l'intermédiaire de résistances d'émetteur, à la première borne d'alimentation.

Selon un mode de réalisation de la présente invention, le ou les transistors sont des transistors de type NPN.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

les figures 1 à 4 décrites précédemment sont destinées à exposer l'état de la technique et le problème posé ;
la figure 5 représente schématiquement un premier mode de réalisation d'un oscillateur à quartz commandé en tension selon la présente invention ;
la figure 6 représente un schéma électrique détaillé de l'oscillateur représenté à la figure 5 ;
la figure 7 représente un schéma équivalent de l'oscillateur représenté à la figure 6 ; et
la figure 8 illustre la caractéristique fréquence-tension différentielle d'un oscillateur selon l'invention.

Pour des raisons de clarté, les mêmes éléments ont été désignés par les mêmes références aux différentes figures.

La figure 5 représente un schéma simplifié d'un mode de réalisation d'un oscillateur à quartz commandé en tension selon la présente invention.

Une caractéristique de l'invention est d'associer un oscillateur 10 de type Colpitts à un circuit actif 11 constituant un déphaseur variable ($\varphi$) commandé en tension (V).

La structure 10 de type Colpitts comporte un transistor To d'oscillation, par exemple de type NPN, dont l'émetteur est connecté, par l'intermédiaire d'un condensateur Ce, à une borne négative M d'alimentation, généralement reliée à la masse. La base du transistor To constitue une borne E de raccordement d'une première borne d'un quartz 1 externe dont une deuxième borne est connectée à la borne M. Une résistance Re de polarisation relie l'émetteur du transistor To à la borne M.

Selon l'invention, l'émetteur du transistor To est également relié à une entrée du circuit actif 11 de déphasage dont une sortie est reliée à la base du transistor To.

Le rôle du circuit actif 11 est de ramener une capacité variable entre la base et l'émetteur du transistor To. La valeur de cette capacité intervient sur la fréquence d'oscillation en modifiant la capacité raccordée en parallèle sur le quartz 1. Le circuit 11 introduit un retard avec gain dans la boucle de réaction entre l'émetteur et la base du transistor To. La commande en tension du circuit 11 revient, fonctionnellement, à faire varier le temps de propagation dans la boucle et, ainsi, la capacité équivalente ramenée entre la base et l'émetteur du transistor To par le circuit 11.

Dans le mode de réalisation représenté à la figure 5, une capacité supplémentaire Cbe est montée entre la borne E et l'émetteur du transistor To pour constituer une association en série des condensateurs Cbe et Ce entre les bornes E et la masse, comme dans un oscillateur Colpitts classique. Le condensateur Cbe est, selon l'invention, optionnel grâce à la capacité équivalente ramenée par le circuit 11 qui peut, le cas échéant, suffire au fonctionnement de l'oscillateur. L'omission du condensateur Cbe permet de réduire l'encombrement du montage.

Le signal modulé est, selon l'invention, prélevé sur une borne S' de sortie, reliée au collecteur du transistor To.

Un avantage de la présente invention est d'utiliser la fréquence de résonance parallèle (fp, figure 4) du quartz 1 (on modifie la capacité équivalente raccordée en parallèle sur le quartz), ce qui permet une plage de modulation sensiblement plus importante que dans un montage à déphaseur classique tel que représenté à la figure 3.

Un autre avantage de l'invention est que, en faisant varier la fréquence de résonance parallèle du quartz pour obtenir la modulation, l'impédance du quartz est maintenue à une valeur sensiblement constante correspondant à sa valeur maximale. Ainsi, l'amplitude du signal de sortie délivré par l'oscillateur est sensiblement constante quelle que soit la fréquence.

Le condensateur Ce et, le cas échéant, le condensateur Cbe, peuvent être intégrés à l'oscillateur, le seul composant externe étant alors le quartz, ou être des condensateurs externes pour permettre à l'utilisateur de modifier la fréquence centrale d'oscillation, c'est-à-dire la fréquence d'oscillation pour un déphasage égal au déphasage central de la plage de variation du circuit 11.

La figure 6 représente un schéma électrique détaillé d'un oscillateur tel que représenté à la figure 5.

Le circuit 11 est constitué d'une structure à entrées différentielles recevant, sur deux bornes 12, 13, des tensions de commande V1, V2 dont la différence $\Delta V$ conditionne la variation de fréquence souhaitée par rapport à la fréquence centrale f0 de l'oscillateur. Les bornes 12 et 13 constituent les bornes d'entrée du signal de modulation que ce soit pour obtenir une modulation de fréquence (FM) ou une modulation par saut de fréquence (FSK) autour de la fréquence centrale f0.

Ainsi, selon la présente invention, la modulation de la fréquence d'oscillation ne nécessite pas une commande dynamique et la fréquence d'oscillation peut être fixée par un niveau de tension continu.

Une première paire différentielle, constituée de transistors T2 et T3, de type NPN, montés en convertisseur tension-courant, constitue la partie de gain du montage. Dans l'exemple représenté à la figure 6, les transistors T2 et T3 sont montés en bases communes et sont polarisés au moyen d'une source de tension constante Vr dont une borne négative est connectée à la masse et dont une borne positive est reliée, par l'intermédiaire d'une résistance Rb2, aux bases des transistor T2 et T3. La source Vr sert également à polariser le transistor To, sa borne positive étant reliée, par l'intermédiaire d'une résistance Rb1, à la base du transistor To. Les émetteurs des transistors T2 et T3 sont chacun connectés, par l'intermédiaire d'une résistance Re2, Re3, à la borne M. Un condensateur C3 est connecté en parallèle sur la résistance Re3, et l'émetteur du transistor T2 est relié à l'émetteur du transistor To.

A titre de variante non représentée, les transistors T2 et T3 pourront être montés en émetteurs communs. Les modifications à apporter à la partie gain du montage pour un montage à émetteurs communs sont à la portée de l'homme de l'art. Le montage à bases communes constitue cependant un mode de réalisation préféré de la présente invention dans la mesure où il minimise le nombre de condensateurs et de résistances utilisés pour la partie gain du montage.

Chaque transistor T2, T3 est associé à un étage différentiel de modulation constitué de deux transistors de type NPN, respectivement, T4, T5 et T6, T7. Les émetteurs des transistors T4 et T5 sont reliés au collecteur du transistor T2. Les émetteurs des transistors T6 et T7 sont reliés au collecteur du transistor T3. Les bases des transistors T4 et T7 sont reliées à la borne 13 et les bases des transistors T5 et T6 sont reliées à la borne 12. Les collecteurs des transistors T4 et T5 sont reliés, indépendamment l'un de l'autre et par l'intermédiaire d'une association en série de résistances R4, R5 et R6, R7, à une borne A d'application d'un potentiel positif d'alimentation Vcc. Le point milieu 14 de l'association en série des résistances R4 et R5 est relié au collecteur du transistor T6. Le point milieu 15 de l'association en série des résistances R6 et R7 est relié au collecteur du transistor T7. Un condensateur Cd de modulation est connecté entre les collecteurs des transistors T4 et T5. Le rôle des transistors T4, T5, T6 et T7 est de moduler, en fonction des tensions du signal modulant, le poids du condensateur Cd dans la boucle constituée entre l'émetteur du transistor To et sa base.

La boucle est refermée sur la base du transistor To au moyen d'au moins un premier condensateur C12, relié entre le collecteur du transistor T4 et la base du transistor To. Le collecteur du transistor To est connecté, par l'intermédiaire d'une résistance de polarisation Rc, à la borne A. Le cas échéant, un deuxième condensateur de boucle C11 relie le point 15 à la base du transistor To.

Quand les tensions V1 et V2 sont égales, les courants de collecteur des transistor T4 et T5 sont égaux et les courants de collecteur des transistor T6 et T7 sont égaux. Il en découle qu'aucun courant ne circule dans le condensateur Cd alors même que les courants qui circulent dans les branches des paires différentielles sont des courants alternatifs. En effet, si la condition d'oscillation du montage est respectée comme on le verra par la suite, le potentiel de l'émetteur du transistor To oscille et les courants I2, I3 des collecteurs des transistors T2 et T3 sont donc des courants alternatifs.

Si la tension V2 est supérieure à la tension V1, les transistor T4 et T7 sont passants, tandis que les transistors T5 et T6 sont bloqués. Il en découle un déséquilibre dans la répartition des courants I2 et I3 et le condensateur Cd est donc traversé par un courant. De même, le condensateur Cd est également traversé par un courant (dans le sens contraire) quand la tension V1 est supérieure à la tension V2. Le déphasage apporté par le condensateur Cd est reporté sur la base du transistor To grâce au condensateur C12 (et, le cas échéant, C11).

Pour que le montage oscille, il faut que la partie réelle de l'impédance vue par le quartz soit, en valeur absolue, supérieure à sa propre résistance série.

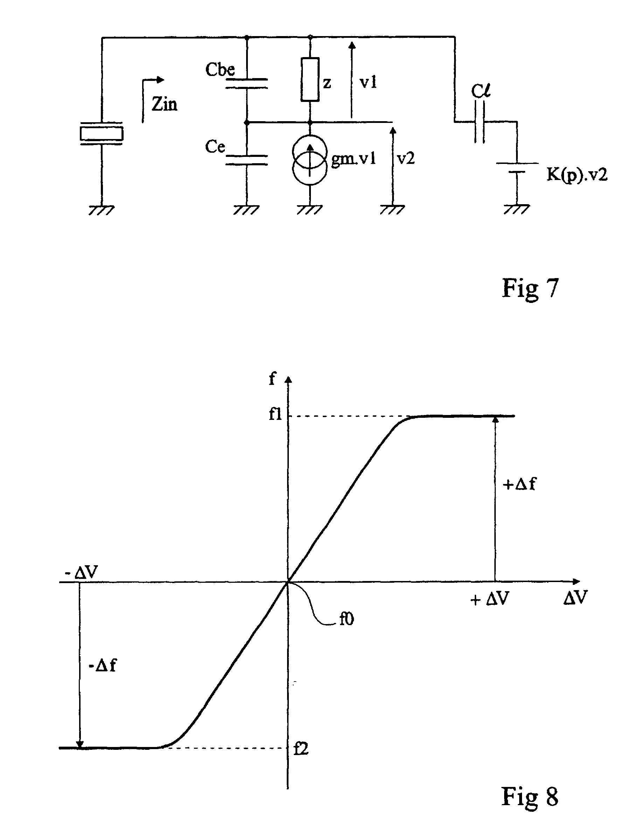

La figure 7 représente le schéma électrique équivalent et simplifié de l'oscillateur représenté à la figure 6. La structure différentielle (les transistors T2, T3, T4, T5, T6, T7, les résistances R4, R5, R6, R7, le condensateur Cd et les résistances de polarisation des transistors T2 et T3) est modélisée sous la forme d'un générateur de tension K(p).

$v_2$, où K(p) représente la fonction de transfert de cette structure différentielle et où $v_2$ représente la tension alternative de l'émetteur du transistor To. Le transistor To est schématisé sous la forme d'une impédance $\underline{z}$ ($r + jc\omega$) et d'un générateur de courant gm.$v_1$, où gm représente la transconductance du transistor To et où $v_1$ représente la tension alternative entre base et émetteur du transistor To. Par souci de simplification, on a regroupé les condensateurs Cl1 et C12 en un condensateur Cl.

En négligeant les termes du deuxième ordre, l'impédance $Z_{in}$ vue par le quartz peut s'écrire sous la forme :

$$Z_{in} = R_{in} + \frac{1}{j \cdot C_{in} \cdot \omega},$$

avec :

$$R_{in} = \frac{-gm}{[(Cbe + c)Ce + (Cbe + c + Ce)Cl - K(j\omega)(Cbe + c)Cl]\omega^2};$$

et

$$C_{in} = \frac{(Cbe + c) \cdot Ce}{(Cbe + c) + Ce} + Cl - K(j\omega) \cdot \frac{(Cbe + c) \cdot Cl}{(Cbe + c) + Ce}.$$

Comme $C_{in}$ est fonction de K(p), la fréquence est également fonction de la fonction de transfert de la structure différentielle.

La fonction de transfert K(p) peut s'exprimer sous la forme :

$$K(p) = K1.th(-\Delta V/2Vt) + K2.Ch(-\Delta V/2Vt) - K3/[1 + exp(-\Delta V/2Vt)],$$

où K1 représente une constante dépendant de la transconductance du transistor T2 ou T3, des résistances R4, R5, R6 et R7 et du condensateur Cd ;

où Vt = kT/Q, avec k représentant la constante de Boltzman, Q la charge de l'électron et T la température en Kelvin ;

où K2 représente une constante dépendant de la transconductance du transistor T2 ou T3, et de la résistance R4 ou R6 ; et

où K3 représente une constante dépendant de la transconductance du transistor T2 ou T3, et de la résistance R5 ou R7.

Il découle de la fonction de transfert de la structure différentielle que quand $\Delta V = 0$, la tangente hyperbolique de l'expression $\Delta V/2Vt$ est nulle et le premier terme dépendant du condensateur Cd est donc nul. La fonction de transfert de la structure différentielle est alors indépendante du condensateur Cd, et la fréquence d'oscillation correspond à la fréquence centrale f0.

Quand la tension différentielle $\Delta V$ varie, la fonction de transfert K(p) varie également et, par voie de conséquence, la partie imaginaire de l'impédance $Z_{in}$ varie, ce qui modifie la fréquence d'oscillation.

La figure 8 représente la caractéristique fréquence-tension différentielle de commande, d'un oscillateur tel que représenté à la figure 6.

Cette caractéristique présente une partie de croissance linéaire de la fréquence f entre deux valeurs d'asymptote f1 et f2 encadrant la fréquence centrale f0. Dans l'exemple représenté à la figure 8, on suppose que les résistances R4, R5, R6 et R7 ont été dimensionnées pour que la caractéristique soit symétrique par rapport à la fréquence f0.

On notera toutefois que les plages d'augmentation $+\Delta f$ et de diminution $-\Delta f$ de la fréquence par rapport à la fréquence centrale f0 peuvent être rendues dissymétriques en modifiant les valeurs de ces résistances.

Comme il ressort de la figure 8, l'oscillateur selon la présente invention peut fonctionner soit en modulation FM, soit en modulation FSK. Pour un fonctionnement en modulation FM, on fera varier la tension différentielle sur la portion linéaire de la caractéristique. Par contre, pour une modulation FSK, on préférera faire varier la tension différentielle entre deux valeurs $+\Delta V$ et $-\Delta V$ suffisamment élevées pour que les fréquences correspondantes se situent dans les parties asymptotiques de la caractéristique. Cela permet de rendre les deux fréquences de la modulation FSK indépendantes d'éventuelles variations des tensions respectivement haute et basse du signal modulant.

On notera que la fréquence centrale f0 et la plage de variation en fréquence doivent être telles que la fréquence du signal modulé soit toujours supérieure à la fréquence de résonance série du quartz utilisé.

**EP 0 859 458 B1**

Un avantage de la présente invention est que l'oscillateur est entièrement paramétrable en conservant une structure identique. Le dimensionnement des composants du circuit déphaseur devra toutefois être adapté à la fréquence centrale f0 choisie pour l'oscillateur. Cette fréquence centrale dépend également des condensateurs Cbe et Ce.

Un autre avantage de la présente invention est que la structure d'oscillateur proposée peut fonctionner sous une faible tension Vcc d'alimentation de l'ordre de 2,7 volts.

Bien entendu, la présente invention est susceptible de diverses variantes et modifications qui apparaîtront à l'homme de l'art. En particulier, le dimensionnement des différents composants sera choisi en fonction de la fréquence centrale souhaitée, donc de la fréquence du quartz. De plus, on pourra, de façon classique, ajouter une inductance et/ou un condensateur en série avec le quartz.


**Revendications**

1. Oscillateur à quartz commandé en tension, comportant un transistor d'oscillation (To) dont la base est reliée à une première borne d'un quartz (1) et dont l'émetteur est connecté, par l'intermédiaire d'un premier condensateur (Ce), à une deuxième borne du quartz reliée à une première borne (M) d'alimentation, **caractérisé en ce qu'**il comporte un circuit actif (11), distinct du transistor d'oscillation, introduisant une capacité variable entre la base et l'émetteur du transistor d'oscillation, le circuit actif étant commandé en tension.

2. Oscillateur selon la revendication 1, **caractérisé en ce qu'**il comporte un deuxième condensateur (Cbe) connecté entre la base et l'émetteur du transistor d'oscillation (To).

3. Oscillateur selon la revendication 1 ou 2, **caractérisé en ce que** le circuit actif (11) est constitué d'une structure à commande différentielle (ΔV) recevant un signal modulant.

4. Oscillateur selon la revendication 3, **caractérisé en ce que** le circuit actif comporte :

   une première partie modulante constituée d'un premier (T4) et d'un deuxième (T5) transistors à émetteurs communs, dont les bases sont respectivement reliées à une première (13) et à une deuxième (12) bornes d'application du signal modulant, et dont les collecteurs sont reliés par un condensateur (Cd) de modulation, le collecteur du premier transistor étant connecté, par l'intermédiaire d'une première association en série de deux résistances (R4, R5), à une deuxième borne (A) d'alimentation, et le collecteur du deuxième transistor étant relié, par l'intermédiaire d'une deuxième association en série de deux résistances (R6, R7), à la deuxième borne d'alimentation ;

   une deuxième partie modulante constituée d'un troisième (T6) et d'un quatrième (T7) transistors à émetteurs communs, dont les bases sont respectivement reliées à la deuxième borne (12) et à la première borne (13) d'application du signal modulant, le collecteur du troisième transistor étant relié au point milieu (14) de ladite première association en série (R4, R5) et le collecteur du quatrième transistor étant relié au point milieu (15) de ladite deuxième association en série (R6, R7) ;

   un montage de gain à transistors (T2, T3), intercalé entre les émetteurs des quatre premiers transistors (T4, T5, T6, T7) et la première borne (M) d'alimentation ; et

   au moins un premier condensateur de boucle (C12) connecté entre le collecteur du premier transistor (T4) et la base du transistor d'oscillation (To).

5. Oscillateur selon la revendication 4, **caractérisé en ce que** ledit deuxième point milieu (15) est relié, par l'intermédiaire d'un deuxième condensateur de boucle (C11), à la base du transistor d'oscillation (To).

6. Oscillateur selon la revendication 4 ou 5, **caractérisé en ce que** les résistances (R4, R5, R6, R7) desdites associations en série sont dimensionnées en fonction de la plage de modulation souhaitée autour d'une fréquence centrale (f0) d'oscillation.

7. Oscillateur selon l'une quelconque des revendications 4 à 6, **caractérisé en ce que** le montage de gain est constitué d'un cinquième transistor (T2) et d'un sixième transistor (T3) montés en bases communes, le collecteur du cinquième transistor étant relié aux émetteurs des premier et deuxième transistors (T4, T5), le collecteur du sixième transistor étant relié aux émetteurs des troisième et quatrième transistors (T6, T7), l'émetteur du cinquième transistor étant relié à l'émetteur du transistor d'oscillation (To) et l'émetteur du sixième transistor étant relié, par l'intermédiaire d'un troisième condensateur (C3), à la première borne (M) d'alimentation.

8. Oscillateur selon la revendication 7, **caractérisé en ce que** les bases des cinquième (T2) et sixième (T3) transistors sont reliées, par l'intermédiaire d'une première résistance de base (Rb2), à une borne d'une source de tension constante (Vr), la base du transistor d'oscillation (To) étant également reliée à ladite borne de la source de tension par l'intermédiaire d'une deuxième résistance de base (Rb1).

9. Oscillateur selon la revendication 7 ou 8, **caractérisé en ce que** les émetteurs respectifs du transistor d'oscillation (To) et des cinquième (T2) et sixième (T3) transistors sont reliés, par l'intermédiaire de résistances d'émetteur (Re, Re2, Re3), à la première borne (M) d'alimentation.

10. Oscillateur selon l'une quelconque des revendications 1 à 9, **caractérisé en ce que** le ou les transistors sont des transistors (To, T2, T3, T4, T5, T6, T7) de type NPN.


**Claims**

1. A voltage-controlled quartz crystal oscillator, including an oscillation transistor (To), the base of which is connected to a first terminal of a quartz crystal (1) and the emitter of which is connected, via a first capacitor (Ce), to a second terminal of the quartz crystal connected to a first supply terminal (M), **characterized in that** it includes an active circuit (11), distinct from the oscillation transistor, introducing a variable capacitance between the base and the emitter of the oscillation transistor, the active circuit being voltage-controlled.

2. The oscillator of claim 1, **characterized in that** it includes a second capacitor (Cbe) connected between the base and the emitter of the oscillation transistor (To).

3. The oscillator of claim 1 or 2, **characterized in that** the active circuit (11). is formed of a structure with a differential control (ΔV), receiving a modulating signal.

4. The oscillator of claim 3, **characterized in that** the active circuit includes:

   a first modulating portion formed by a first (T4) and of a second (T5) transistors with common emitters, the bases of which are respectively connected to a first (13) and to a second (12) terminals of application of the modulating signal, and the collectors of which are connected by a modulation capacitor (Cd), the collector of the first transistor being connected, via a first series connection of two resistors (R4, R5), to a second supply terminal (A), and the collector of the second transistor being connected, via a second series connection of two resistors (R6, R7), to the second supply terminal;
   a second modulating portion formed by a third (T6) and of a fourth (T7) transistors with common emitters, the bases of which are respectively connected to the second terminal (12) and to the first terminal (13) of application of the modulating signal, the collector of the third transistor being connected to the midpoint (14) of the first series connection (R4, R5) and the collector of the fourth transistor being connected to the midpoint (15) of the second series connection (R6, R7);
   a gain assembly with transistors (T2 T3), interposed between the emitters of the four first transistors (T4, T5, T6, T7) and the first supply terminal (M); and
   at least one first loop capacitor (C12), connected between the collector of the first transistor (T4) and the base of the oscillation transistor (To).

5. The oscillator of claim 4, **characterized in that** the second midpoint (15) is connected, via a second loop capacitor (C11), to the base of the oscillation transistor (To).

6. The oscillator of claim 4 or 5, **characterized in that** the resistors (R4, R5, R6, R7) of the series connections are sized according to the desired modulation range around a central oscillation frequency (f0).

7. The oscillator of any of claims 4 to 6, **characterized in that** the gain assembly is formed of a fifth transistor (T2) and of a sixth transistor (T3) having commonly-connected bases, the collector of the fifth transistor being connected to the emitters of the first and second transistors (T4, T5), the collector of the sixth transistor being connected to the emitters of the third and fourth transistors (T6, T7), the emitter of the fifth transistor being connected to the emitter of the oscillation transistor (To) and the emitter of the sixth transistor being connected, via a third capacitor (C3), to the first supply terminal (M).

8. The oscillator of claim 7, **characterized in that** the bases of the fifth (T2) and sixth (T3) transistors are connected, via a first base resistor (Rb2), to a terminal of a source of constant voltage (Vr), the base of the oscillation transistor (To) being also connected to the terminal of the voltage source via a second base resistor (Rb1).

9. The oscillator of claim 7 or 8, **characterized in that** the respective emitters of the oscillation transistor (To) and of the fifth (T2) and sixth (T3) transistors are connected, via emitter resistors (Re, Re2, Re3), to the first supply terminal (M).

10. The oscillator of any of claims 1 to 9, **characterized in that** the transistor(s) are NPN-type transistors (To, T2, T3, T4, T5, T6, T7).

**Patentansprüche**

1. Ein spannungsgesteuerter Quarzkristalloszillator, der einen Oszillationstransistor (To) aufweist, dessen Basis mit einem ersten Anschluß eines Quarzkristalls (1) verbunden ist und dessen Emitter über einen ersten Kondensator (Ce) mit einem zweiten Anschluß des Quarzkristalls verbunden ist, der mit einem ersten Versorgungsanschluß (M) verbunden ist, **gekennzeichnet dadurch, daß** er einen aktiven Schaltkreis (11) aufweist, und zwar unterschiedlich bzw. getrennt vom Oszillationstransistor, der eine variable Kapazität zwischen der Basis und dem Emitter des Oszillationstransistors einführt, wobei der aktive Schaltkreis spannungsgesteuert ist.

2. Oszillator nach Anspruch 1, **dadurch gekennzeichnet, daß** er einen zweiten Kondensator (Cbe) aufweist, der zwischen der Basis und dem Emitter des Oszillationstransistors (To) verbunden ist.

3. Oszillator nach Anspruch 1 oder 2, **dadurch gekennzeichnet, daß** der aktive Schaltkreis (11) aus einer Struktur mit einer Differentialsteuerung ($\Delta$V) gebildet ist, die ein modulierendes Signal empfängt.

4. Oszillator nach Anspruch 3, **dadurch gekennzeichnet, daß** der aktive Schaltkreis folgendes aufweist:

einen ersten modulierenden Teil, und zwar gebildet aus einem ersten (T4) und einem zweiten (T5) Transistor mit gemeinsamen-Emittern, wobei die Basen derselben jeweils mit einem ersten (13) und einem zweiten (12) Anleganschluß des modulierenden Signals verbunden sind, und wobei die Kollektoren derselben mit einem Modulationskondensator (Cd) verbunden sind, wobei der Kollektor des ersten Transistors über eine erste serielle Verbindung von zwei Widerständen (R4, R5) mit einem zweiten Versorgungsanschluß (A) verbunden ist, und wobei der Kollektor des zweiten Transistors über eine serielle Verbindung von zwei Widerständen (R6, R7) mit dem zweiten Versorgungsanschluß verbunden ist;
einen zweiten modulierenden Teil, und zwar gebildet aus einem dritten (T6) und einem vierten (T7) Transistor mit gemeinsamen Emittern, wobei die Basen derselben jeweils mit dem zweiten Anschluß (12) und dem ersten Anschluß (13) für das Anlegen des modulierenden Signals verbunden sind, wobei der Kollektor des dritten Transistors über einen Mittelpunkt (14) der ersten seriellen Verbindung (R4, R5) verbunden ist und der Kollektor des vierten Transistors mit dem Mittelpunkt (15) der zweiten seriellen Verbindung (R6, R7) verbunden ist;
eine Verstärkungsanordnung mit Transistoren (T2, T3), die zwischen den Emittern der vier ersten Transistoren (T4, T5, T6, T7) und dem ersten Versorgungsanschluß (M) angeordnet ist; und
zumindest einen ersten in Schleife geschalteten Kondensator (C12), der zwischen dem ersten Transistor (T4) und der Basis des Oszillationstransistors (To) verbunden ist.

5. Oszillator nach Anspruch 4, **dadurch gekennzeichnet, daß** der zweite Mittelpunkt (15) über einen zweiten in Schleife geschalteten Kondensator (C11) mit der Basis des Oszillationstransistors (To) verbunden ist.

6. Oszillator nach Anspruch 4 oder 5, **dadurch gekennzeichnet, daß** die Widerstände (R4, R5, R6, R7) der seriellen Verbindungen gemäß dem gewünschten Modulationsbereich um eine mittige Oszillationsfrequenz (f0) ausgelegt sind.

7. Oszillator nach einem der Ansprüche 4 bis 6, **dadurch gekennzeichnet, daß** die Verstärkungsanordnung aus einem fünften Transistor (T2) und einem sechsten Transistor (T3) mit gemeinsam verbundenen Basen gebildet ist, wobei der Kollektor des fünften Transistors mit den Emittern der ersten und zweiten Transistoren (T4, T5) verbunden ist, wobei der Kollektor des sechsten Transistors mit den Emittem der dritten und vierten Transistoren (T6, T7) verbunden ist, wobei der Emitter des fünften Transistors mit dem Emitter des Oszillationstransistors (To) verbunden ist, und wobei der Emitter des sechsten Transistors über einen dritten Kondensator (C3) mit dem ersten Versorgungsanschluß (M) verbunden ist.

8. Oszillator nach Anspruch 7, **dadurch gekennzeichnet, daß** die Basen der fünften (T2) und sechsten (T3) Transistoren über einen ersten Basiswiderstand (Rb2) mit einem Anschluß einer Quelle für konstante Spannung (Vr) verbunden sind, wobei die Basis des Oszillationstransistors (To) mit dem Anschluß der Spannungsquelle über einen zweiten Basiswiderstand (Rb1) verbunden ist.

9. Oszillator nach Anspruch 7 oder 8, **dadurch gekennzeichnet, daß** die jeweiligen Emitter des Oszillationstransistors (To) und der fünften (T2) und sechsten (T3) Transistoren über Emitterwiderstände (Re, Re2, Re3) mit dem ersten Versorgungsanschluß (M) verbunden sind.

10. Oszillator nach einem der Ansprüche 1 bis 9, **dadurch gekennzeichnet, daß** die Transistoren NPN-Typ-Transistoren (To, T2, T3, T4, T5, T6, T7) sind.

Fig 1

Fig 2

Fig 3

11

Fig 4

Fig 5

Fig 6

Fig 7

Fig 8